# EUROPEAN PATENT SPECIFICATION

(11) **EP 0 410 116 B1**
(45) Date of publication and mention of the grant of the patent: **06.09.1995**
(21) Application number: 90110621.1
(22) Date of filing: 05.06.1990
(51) Int. Cl.: H01L 21/60, H01L 23/495

(54) **Method of manufacturing a wire-bonded semiconductor device**
Verfahren zur Herstellung einer Halbleiteranordnung durch "Wire-bonding"
Procédé de fabrication d'un dispositif semiconducteur à connexion par fil

(30) Priority: 28.06.1989 JP 163686/89
(43) Date of publication of application: 30.01.1991
(73) Proprietor: KABUSHIKI KAISHA TOSHIBA, Kawasaki-shi, Kanagawa-ken 210 (JP)
(72) Inventor: Ikenoue, Kazuhisa, C/o Intellectual Property Div., Minato-ku, Tokyo 105 (JP)
(74) Representative: Lehn, Werner, Dipl.-Ing.

(56) References cited:
- EP-A- 0 108 502
- EP-A- 0 354 696

## Description

The present invention relates to a semiconductor device, wherein a semiconductor chip is mounted on the bed of a first frame, the tip end of each of the inner leads of a second frame is located above the semiconductor chip, and the bonding pads of the semiconductor chip and the inner leads of the second frame are connected together by bonding wires. The present invention also relates to a method for manufacturing this type of semiconductor device.

Among well-known semiconductor devices, there is a type wherein a semiconductor chip is mounted on the bed of a first frame, the tip end of each of the inner leads of a second frame is located above the semiconductor chip, and the bonding pads of the semiconductor chip and the inner leads of the second frame are connected together by bonding wires. In this type of semiconductor device, the route extending from one inner lead of the second frame leading to the corresponding bonding pad is long. In the case where this route is long, water hardly enters the interior of the semiconductor device since the route becomes a water route in most cases. Therefore, the above-mentioned type of semiconductor device is advantageous, in that a comparatively small-sized package, formed of sealing resin, can be employed for housing a large-sized chip.

However, the process for manufacturing the above semiconductor device is faced with the problems below.

When the inner leads of the second frame and their corresponding bonding pads are connected together by bonding wires, a passivation film formed on the surface of the semiconductor chip is likely to crack, due to the bonding force. Such a crack degrades the moisture-resisting of the semiconductor device. Moreover, if such a crack is deep, it may happen that semiconductor elements will be destroyed. Under these circumstances, conventional semiconductor devices of the above-mentioned type are not very reliable in operation, and the manufacturing yield of them is not very high.

EP-A-0 108 502 and EP-A-0 354 696 show insulating layers which can protect the semiconductor layers from damage by bonding wires or inner leads.

To solve these problems, the inventor of the present invention considered coating the surface of the semiconductor chip with a shock-absorbing film. To achieve a sufficient shock-absorbing effect, however, the thickness of the film has to be more than a certain value. If the coated film is too thick, it contracts during the coating step. Since, in this case, the wafer coated with the film is subjected to physical stress, it may warp, resulting in damage to it.

The inventor also considered forming a shock-absorbing film on those portions of the second frame which face the semiconductor chip, so as to sufficiently absorb a shock. However, the interface between different materials is likely to become a water route along which water enters the interior of a resin-sealed semiconductor device. Therefore, if the shock-absorbing film is formed on the second frame, not only the interface between the molded resin and the second frame but also the interface between the molded resin and the shock-absorbing film may become a water route. Thus, water is easy to enter the interior of a semiconductor device if this semiconductor device has a shock-absorbing film coated on the second frame.

Accordingly, an object of the present invention is to prevent application of shock, when bonding is performed on a semiconductor chip to fabricate a semiconductor device. Another object of the invention is to improve both the reliability and manufacturing yield of semiconductor devices to be fabricated.

To achieve these objects, the present invention provides a method of manufacturing a semiconductor device, comprising the steps:
applying a layer of shock-absorbing electrically insulating material to a predetermined portion on one side of a plate-like second lead frame material;
punching the second lead frame material, applied with the shock-absorbing layer material, into a predetermined shape, to thereby form a second lead frame having a plurality of inner leads and a shock-absorbing layer applied at least to the tip end of each inner lead;
preparing a first lead frame having a chip-support bed; mounting a semiconductor chip having a plurality of bonding pads on the surface opposing the mounting surface thereof on said bed;
adjusting the position of the second lead frame such that the inner leads of the second lead frame are located above said opposing surface of the semiconductor chip and such that the shock-absorbing layer faces said opposing surface of the semiconductor chip; and
connecting respective ones of the bonding pads of the semiconductor chip to respective ones of the tip ends of the inner leads by bonding wires.

In a semiconductor device thus manufactured, the shock-absorbing layer is formed on that surface portion of the inner lead which faces the semiconductor chip. Since the shock-absorbing layer serves to absorb a shock which may be applied to the semiconductor chip during a bonding operation, the semiconductor chip is prevented from cracking and the semiconductor element is prevented from being damaged. It should be also noted that the shock-absorbing layer is formed only at a portion where it is necessary, and that the shock-absorbing layer is not exposed to the outside after the semiconductor chip is sealed by a sealing resin layer. Since, therefore, the interface between the shock-absorbing layer and a member in contact therewith does not become a water route, electric leakage arising from the provision of the shock-absorbing layer is prevented.

This invention can be more fully understood from the following detailed description when taken in conjunction with the accompanying drawings, in which:

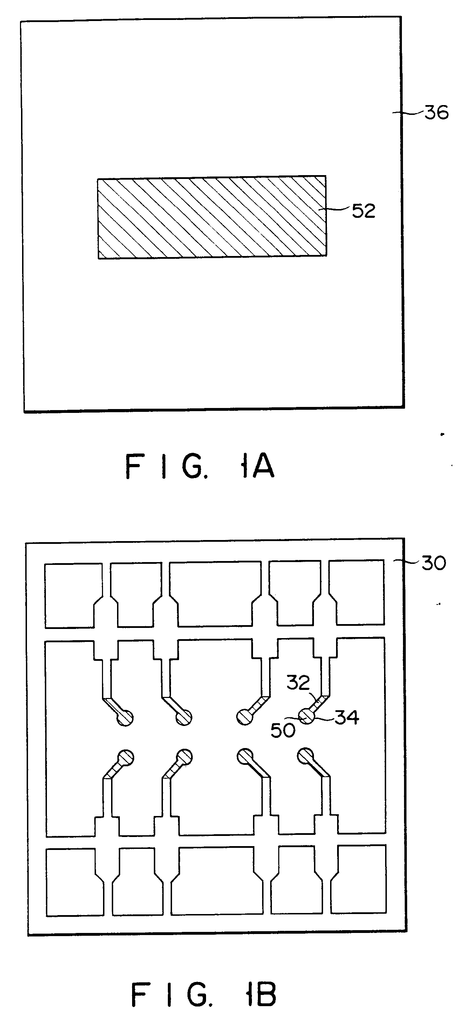

Figs. 1A through 1D are views illustrating the steps of an example of a process by which to manufacture a semiconductor device of the present invention.

As is shown in Fig. 1A, a plate-like second frame material 36 is prepared. This material 36 is a Fe-Ni alloy such as 42-alloy, Cu, or the like. A sheet-like shock-absorbing layer material 52 is applied to a predetermined portion on one side of the plate-like second frame material 36. Any kind of material may be used as the shock-absorbing layer material 52, as long as it is an electric insulator and can resist such heat as is produced in the heating atmosphere utilized in the manufacturing process of the semiconductor device. As the shock-absorbing layer material 52, epoxy resin may be used, but polyimide resin is more desirable. The thickness of the shock-absorbing layer material 52 is preferably within the range of 30 to 50 µm. The application of the shock-absorbing layer material to the second frame material is carried out, for example, by the adhesion used in a printing process.

The second frame material 36, applied with the shock-absorbing layer material 52, is punched into a predetermined shape, to thereby form a second frame 30 (which is indicated by the oblique lines in the Figures). As is shown in Fig. 1B, the second frame 30 has inner leads 32 and shock-absorbing layers 50 adhered at least to the tip end 34 of each inner lead 32. The second frame material 36 is punched from the side to which the shock-absorbing layer material 52 is applied, since the punching from this side leaves no burr.

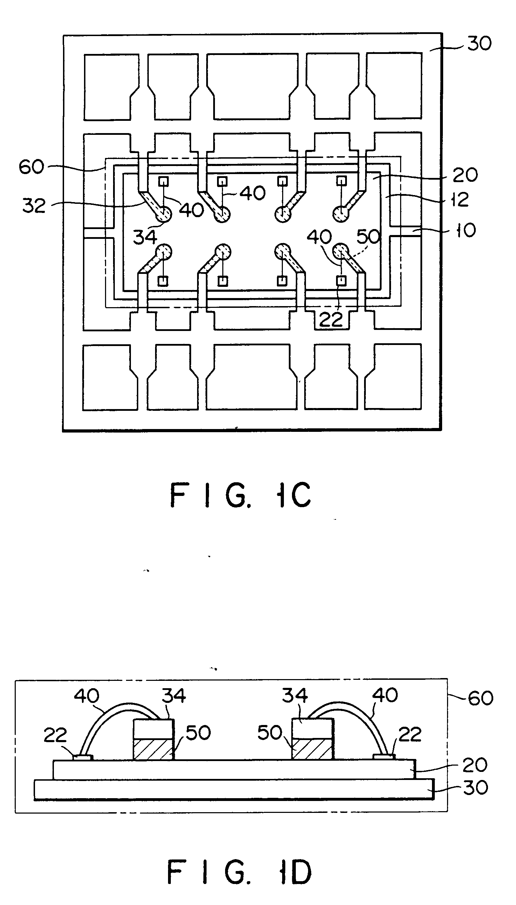

Next, a first frame 10 having a bed 12 is prepared, as is shown in Fig. 1C. A semiconductor chip 20 having bonding pads 22 is mounted on the bed 12. In this condition, the position of the second frame 30 is adjusted such that the inner leads 32 of the second frame 30 are located above the semiconductor chip 20 and such that the shock-absorbing layers 50 face the surface of the semiconductor chip 20. After the position of the second frame 30 is adjusted in this manner, the first frame 10 and the second frame 30 are bonded together by spot welding. Thereafter, the bonding pads 22 of the semiconductor chip 20 are connected, by means of bonding wires 40, to the tip ends 34 of the corresponding inner leads 32 of the second frame 30 which is located above the semiconductor chip 20.

Finally, a sealing resin layer 60 is provided for the region indicated by the two-dot-dash lines in the Figures. By this sealing resin layer, the first frame 10, the semiconductor chip 20, the second frame 30, the bonding wires 40, and the shock-absorbing layers 50 are sealed and secured.

As is shown in Figs. 1C and 1D, a semiconductor device manufactured in the above-mentioned manner comprises: a first frame 10 having a bed 12; a semiconductor chip 20 mounted on the bed 12 and having a bonding pad 22; a second frame 30 having an inner lead located above the semiconductor chip 20; a bonding wire 40 connecting the bonding pad 22 of the semiconductor chip 20 to the tip end 34 of the inner lead 32; and a shock-absorbing layer 50 which is adhered at least to that surface portion of the tip end 34 of the inner lead 32 which faces the semiconductor chip 20.

Reference numbers have been included in the claims for reference purposes only and do not alter the scope.

## Claims

1. A method of manufacturing a semiconductor device, comprising the steps:
applying a layer of shock-absorbing electrically insulating material (52) to a predetermined portion on one side of a plate-like second lead frame material (36);
punching the second lead frame material (36), applied with the shock-absorbing layer material (52), into a predetermined shape, to thereby form a second lead frame (30) having a plurality of inner leads (32) and a shock-absorbing layer (50) applied at least to the tip end (34) of each inner lead (32);
preparing a first lead frame (10) having a chip-support bed (12); mounting a semiconductor chip (20) having a plurality of bonding pads (22) on the surface opposing the mounting surface thereof on said bed (12);
adjusting the position of the second lead frame (30) such that the inner leads (32) of the second lead frame (30) are located above said opposing surface of the semiconductor chip (32) and such that the shock-absorbing layer (50) faces said opposing surface of the semiconductor chip (20); and
connecting respective ones of the bonding pads (22) of the semiconductor chip (20) to respective ones of the tip ends (34) of the inner leads (32) by bonding wires (4).

2. A method according to claim 1, characterized in that said applying step includes a step of adhering the shock-absorbing layer material (52) to the second frame material (36) by use of an adhesive.

3. A method according to claim 1, characterized in that said applying step includes a step of adhering the shock-absorbing layer material (52) to the second frame material (36) by printing.

4. A method according to claim 1, 2, or 3, characterized by further comprising a step of resin-sealing the first frame (10), the semiconductor chip (20), the second frame (30), the bonding wire (40), and the shock-absorbing layer (50).

5. A method according to any preceding claim characterized in that said punching step includes a step of punching the second frame material (36) from the side to which the shock-absorbing layer material (52) is applied.

## Patentansprüche

1. Verfahren zur Herstellung einer Halbleitereinrichtung, umfassend die folgenden Schritte:
Anbringen einer Schicht aus stoß-absorbierendem elektrisch isolierendem Material (52) an einen vorgegebenen Abschnitt auf einer Seite eines plattenartigen zweiten Zuleitungsrahmenmaterials (36);
Stanzen des zweiten Zuleitungsrahmenmaterials (36), mit dem angebrachten stoß-absorbierenden Schichtmaterial (52), in eine vorgegebene Form, um dadurch eine zweiten Zuleitungsrahmen (30) mit einer Vielzahl von inneren Zuleitungen (32) und eine auf wenigstens das Spitzenende (34) jeder inneren Zuleitung (32) angebrachten stoßabsorbierenden Schicht (50) zu bilden;
Erstellen eines ersten Zuleitungsrahmens (10) mit einem Chiphalterungs-Bett (12);
Anbringen eines Halbleiterchips (20) mit einer Vielzahl von Bondierungs-Flecken (22) auf die Oberfläche, die der Anbringungsoberfläche davon auf dem zweiten Bett (12) gegenüberliegt;
Einstellen der Position des zweiten Zulassungsrahmens (30), so daß sich die inneren Zuleitungen (32) des zweiten Zuleitungsrahmens (30) über der gegenüberliegenden Oberfläche des Halbleiterchips (32) efinden und so, daß die stoß-absorbierende Schicht (50) der gegenüberliegenden Oberfläche des Halbleiterchips (20) zugekehrt ist; und
Verbinden von jeweiligen der Bondierungsflecken (22) des Halbleiterchips (20) mit jeweiligen der spitzen Enden (34) der inneren Zuleitungen (32) durch Bondierungs-Drähte (4).

2. Verfahren nach Anspruch 1,
dadurch **gekennzeichnet**, daß
der Anbringungsschritt einen Schritt einer Anhaftung des stoß-absorbierenden Schichtmaterials (32) an das zweite Rahmenmaterial (36) unter Verwendung eines Klebemittels umfaßt.

3. Verfahren nach Anspruch 1,
dadurch **gekennzeichnet**, daß
der Anbringungsschritt einen Schritt einer Anhaftung des stoß-absorbierenden Schichtmaterials (32) an dem zweiten Rahmenmaterial (36) durch Drucken umfaßt.

4. Verfahren nach Anspruch 1, 2 oder 3,
dadurch **gekennzeichnet**, daß
es ferner folgenden Schritt umfaßt: Harzvergießen des ersten Rahmens (10), des Halbleiterchips (20), des zweiten Rahmens (30), des Bondierungs-Drahts (40) und der stoß-absorbierenden Schicht (50).

5. Verfahren nach einem der vorangehenden Ansprüche,
dadurch **gekennzeichnet**, daß
der Stanzschritt einen Schritt eines Stanzens des zweiten Rahmenmaterials (36) von der Seite, an der das stoß-absorbierende Schichtmaterial (52) angebracht ist, umfaßt.

## Revendications

1. Procédé de fabrication d'un dispositif à semiconducteur, comprenant les étapes consistant à:
- appliquer une couche de matière électriquement isolante absorbant les chocs (52) à une partie prédéterminée sur un côté d'une matière d'un deuxième cadre à conducteurs en forme de plaque 36;
- découper au poinçon la matière du deuxième cadre à conducteurs (36) ayant la matière absorbant les chocs (52) pour lui donner une forme prédéterminée pour former par ce moyen un deuxième cadre à conducteurs (30) ayant une pluralité de conducteurs intérieurs et une couche absorbant les chocs (50) appliquée à au moins l'extrémité (34) de chaque conducteur intérieur (32);
- confectionner un premier cadre à conducteurs 10 ayant une surface de portée (12) pour supporter une puce; monter une puce de semiconducteur (20) ayant une pluralité de plages de connexion (22) sur la surface opposée à la surface de montage de celle-ci sur la surface de portée (12);
- régler la position du deuxième cadre à conducteurs (30) de telle manière que les conducteurs intérieurs (32) du deuxième cadre à conducteurs (30) soient situés au-dessus de ladite surface opposée de la puce de semiconducteur (32) et de telle manière que la couche absorbant les chocs fasse face à ladite surface opposée de la puce de semiconducteur (20); et
- connecter les plages de connexion respectives de la puce de semiconducteur (20) aux extrémités respectives (34) des conducteurs intérieurs (32) par des fils de connexion soudés (4).

2. Procédé selon la revendication 1, caractérisé en ce que ladite étape d'application comprend une étape consistant à coller la matière du deuxième cadre à conducteurs (52) à la matière du deuxième cadre à conducteurs (36) à l'aide d'un adhésif.

3. Procédé selon la revendication 1, caractérisé en ce que ladite étape d'application comprend une étape consistant à coller la matière absorbant les chocs (52) à la matière du deuxième cadre (36) par sérigraphie.

4. Procédé selon la revendication 1, 2 ou 3, caractérisé en ce qu'il comprend en outre une étape consistant à enrober hermétiquement avec de la résine le premier cadre à conducteurs (10), la puce de semiconducteur (20), le deuxième cadre (30), les fils de connexion soudés (40) et la couche absorbant les chocs (50).

5. Procédé selon l'une quelconque des revendications précédentes, caractérisé en ce que ladite étape de découpage au poinçon comprend une étape consistant à découper au poinçon la matière du deuxième cadre (36) à partir du côté auquel la matière absorbant les chocs (52) est appliquée.
